Europäisches Patentamt

**European Patent Office**

Office européen des brevets

(11) Veröffentlichungsnummer: **0 060 256**
**B1**

# EUROPÄISCHE PATENTSCHRIFT

(45) Veröffentlichungstag der Patentschrift:
10.06.87

(51) Int. Cl.⁴: **G 01 L 9/10**

(21) Anmeldenummer: **81901812.8**

(22) Anmeldetag: **12.06.81**

(86) Internationale Anmeldenummer:
**PCT/EP 81/00073**

(87) Internationale Veröffentlichungsnummer:
**WO 82/01067 (01.04.82 Gazette 82/09)**

(54) **INDUKTIVER DRUCKSENSOR.**

(30) Priorität: **18.09.80 DE 3035186**

(43) Veröffentlichungstag der Anmeldung:
**22.09.82 Patentblatt 82/38**

(45) Bekanntmachung des Hinweises auf die Patenterteilung:
**10.06.87 Patentblatt 87/24**

(84) Benannte Vertragsstaaten:
**CH DE FR GB LI SE**

(56) Entgegenhaltungen:
FR-A-989 771
FR-A-1 359 334
FR-A-2 167 076
GB-A-890 944
GB-A-2 063 485

IEEE Transactions on microwave theory and techniques, MTT-16, nr. 7, July 1968, New York, US, PRESSER u.a.: "Hybrid integrated L-Band Transmitter", pages 482-483
Mc Graw Encyclopedia, vol. 5, (1977), S. 236

(73) Patentinhaber: **ROBERT BOSCH GMBH, Postfach 50, D-7000 Stuttgart 1 (DE)**

(72) Erfinder: **BAUM, Helmut, Rembrandstrasse 30, D-7000 Stuttgart 80 (DE)**
Erfinder: **PFIZENMAIER, Heinz, Liststrasse 6, D-7250 Leonberg (DE)**
Erfinder: **SCHMIDT, Ewald, Bachstrasse 10, D-7140 Ludwigsburg (DE)**
Erfinder: **STRAUSS, Franz, Am Schattwald 8, D-7000 Stuttgart 80 (DE)**

(74) Vertreter: **Witte, Alexander, Dr.- Ing., c/o Robert Bosch GmbH Robert- Bosch- Platz 1, D-7016 Gerlingen- Schillerhöhe (DE)**

EP 0 060 256 B1

## Beschreibung

### Stand der Technik

Die Erfindung geht aus von einem induktiven Drucksensor nach der Gattung des Hauptanspruches.

Aus der CH-PS 489 792 ist bereits ein Induktions-Differenzdruckgeber bekannt, bei dem zwei in Brückenschaltung geschaltete Spulenanordnungen in Wechselwirkung mit einer differenzdruckabhängig auslenkbaren Membran stehen. Dabei wird durch die Auslenkung der Membran die Induktivität der jeweiligen Spulen bzw. Spulenanordnungen verändert, wodurch eine Frequenzverschiebung eines Oszillators bewirkt wird, bei dem die Spulen frequenzbestimmende Bauelemente sind.

Die bekannte Vorrichtung hat jedoch einmal den Nachteil, daß durch die Ausbildung der Spulenanordnung als Ferrit-Topfkerne eine relativ große Bauhöhe erforderlich ist. Zum anderen hat die bekannte Vorrichtung den Nachteil, daß keine besonderen Vorkehrungen getroffen sind, um ein durch Temperaturschwankungen verursachtes Wegdriften der Oszillatorfrequenz zu vermeiden.

Aus der FR-A-989 771 ist eine Vorrichtung zur Messung physikalischer Größen, etwa eine bacometrische Kapsel, bekannt, die die Veränderung der Eigenfrequenz von Oszillatorschaltkreisen in Abhängigkeit der Größen benutzt. Dabei werden zwei flächige, räumlich benachbarte Spulen als Übertrager verwendet, dessen Übertragungsfaktor oder Kopplungsfaktor der Spulen verändert wird. Dies geschieht etwa durch Veränderung des räumlichen Spulenabstandes oder durch Einbringen von elektromagnetisch wirksamen Materialien in das Koppelfeld.

Aus der FR-A-2 167 076 ist eine Druck- oder Differenzdruckmeßzelle bekannt. Sie enthält eine druckbeaufschlagbare Membran, deren Auslenkung die Induktivität einer ebenfalls in der Zelle angeordneten flächigen Spule verändert.

Aus der Druckschrift "McGraw Encyclopedia", Vol. 5 (1977) Seite 236 ist bekannt, daß ferritsche Materialien besonders hohe Permeabilitätszahlen aufweisen.

Aus der GB-A-880 944 ist eine Hochfrequenz-Sonde zur barometischen Druckmessung bekannt, bei der eine flächige Spule mit hochfrequentem Strom beaufschlagt wird und ein an einer Druckmeßdose befestigtes Leitstück die Induktivität der Spule durckabhängig variiert.

### Vorteile der Erfindung

Der erfindungsgemäße Drucksensor mit den kennzeichnenden Merkmalen des Hauptanspruches hat gegenüber den bekannten Drucksensoren den Vorteil, daß durch die Verwendung zweier baugleicher Oszillatoren, die räumlich zusammen angeordnet und damit gleichen Temperaturbedingungen ausgesetzt sind, erreicht wird, daß bei einer Ausnutzung des durch Mischung gewonnen Oszillatorsignales das temperaturabhängige Driften der Oszillatoren kompensiert wird. Dabei sind in vorteilhafter Weise einmal durch Einstellen einer Festfrequenz des einen Oszillators Absolutdruckmessungen und Differenzdruckmessungen gegenüber Atmosphären-Druck und zum anderen Differenzdruckmessungen zwischen zwei Medien möglich, wenn beide Oszillatoren mit den jeweils zugehörigen Spulen und Membranen unterschiedlichen Drücken ausgesetzt sind.

Schließlich wird mittels der Erfindung eine besonders kompakte Bauweise und damit auch besondere gute thermische Kopplung der Oszillatoren dadurch erreicht, daß die Oszillatoren als Dünnschichtelemente ausgebildet sind, die sich zusammen mit der als flächige Spirale gestalteten Spule auf einem Träger befinden. Dabei kann zur Realisierung eines besonders kostengünstigen Sensors auch eine Anordnung mit einer gedruckten Leiterplatte Verwendung finden.

### Zeichnung

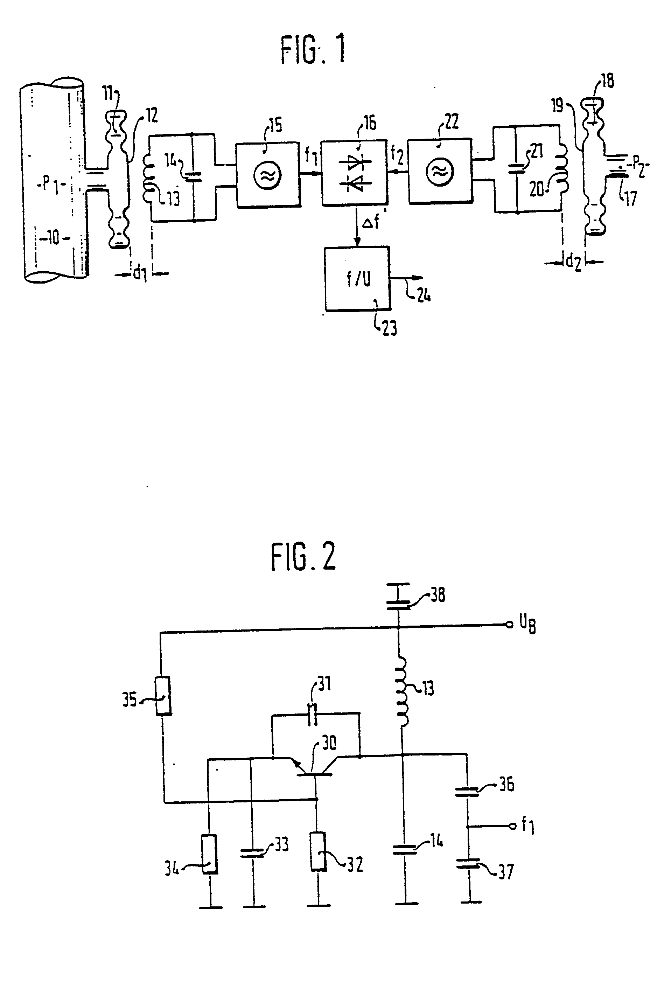

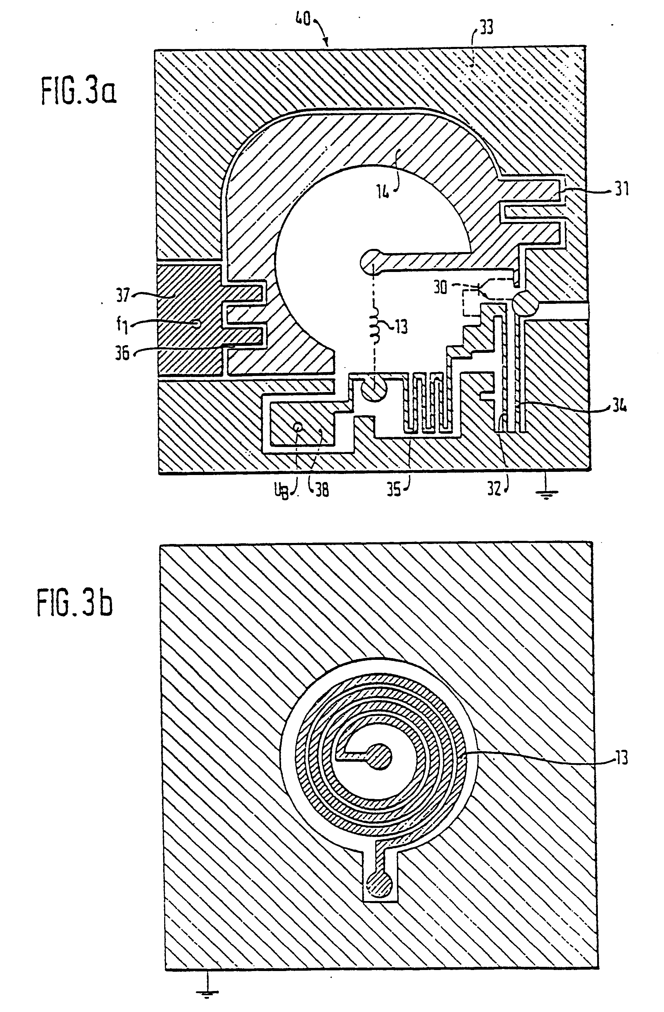

Die Erfindung ist in der Zeichnung dargestellt und in der nachfolgenden Beschreibung näher erläutert. Es zeigen Figur 1 eine Prinzipdarstellung in Form eines Blockschaltbildes einer Ausführungsform eines erfindungsgemäßen Drucksensors; Figur 2 das Schaltbild eines Oszillators, wie er zweckmäßigerweise bei der in Figur 1 dargestellten Anordnung verwendet werden kann; Figuren 3a und b die Vorder- bzw. Rückseite einer Dünnschichtmaske zur Realisierung des in Figur 2 dargestellten Oszillators.

### Beschreibung des Ausführungsbeispieles

Bei verschiedenen Meß- und Regelaufgaben is es erforderlich, den Druck eines Gases entweder absolut oder relativ gegenüber einem zweiten Druck zu messen. Beispielhaft seien hier nur die Saugrohrdruckmessung einer Brennkraftmaschine eines Kraftfahrzeuges, die Füllstandsmessung oder die elektrische Blutdruckmessung in der Medizintechnik genannt.

Bei dem in Figur 1 dargestellten Ausführungsbeispiel eines erfindungsgemäßen Drucksensors ist die Anwendung bei der Saugrohrdruckmessung einer Brennkraftmaschine eines Kraftfahrzeuges dargestellt. Es versteht sich jedoch von selbst, daß der angegebene Drucksensor auch bei den anderen, ebenfalls lediglich beispielhaft genannten Meßaufgaben einsetzbar und keinesfalls auf das geschilderte Ausführungsbeispiel beschränkt ist.

In Figur 1 ist mit 10 das Saugrohr einer Brennkraftmaschine eines Kraftfahrzeuges bezeichnet. Im Saugrohr herrscht ein Unterdruck $p_1$. Das Saugrohr 10 steht über eine Leitung mit einer ersten Druckdose 11 in Verbindung, die auf der einen Seite von einer Membran 12 abgeschlossen is Im Abstand $d_1$ von der Membran 12 ist eine Spule 13 angeordnet, die zusammen mit einem Kondensator 14 das frequenzbestimmende Element eines ersten Oszillators 15 bildet. Entsprechend den Werten der Spule 13 und des Kondensators 14 liefert Frequenz $f_1$. In entsprechender Weise ist über ein Meßrohr 17 eine zweite Druckdose 18 an den Außendruck $p_2$ angeschlossen. Die zweite Druckdose 18 weist ebenfalls eine Membran 19 auf, die im Abstand $d_2$ von einer Spule 20 angeordnet ist, die mit einem Kondensator 21 das frequenzbestimmende Element eines zweiten Oszillators 22 bildet, der - wie oben geschildert - ein Ausgangssignal mit der Frequenz $f_2$ liefert. Der erste Oszillator 15 und der zweite Oszillator 22 sind an einen Mischer 16 angeschlossen, an dessen Ausgang ein Signal mit der Frequenz $\Delta f = f_2 - f_1$ anliegt. Dieses Ausgangssignal wird einem Frequenz/Spannungswandler 23 zugeführt, dessen Ausgang 24 mit einer in der Figur nicht dargestellten Auswerteschaltung verbunden ist.

Die Wirkungsweise der in Figur 1 dargestellten Vorrichtung ist wie folgt: Die Membranen 12 bzw. 19 der ersten Druckdose 11 bzw. der zweiten Druckdose 18 sind mit einer hochleitenden oder ferritischen Oberfläche versehen. Die Spulen 13 bzw. 20 sind flächenhaft ausgebildet und die Abstände $d_1$ bzw. $d_2$ sind sehr gering gewählt. Werden nun die Membranen 12 bzw. 19 durch die Drücke $p_1$ bzw. $p_2$ ausgelenkt, ändert sich die Induktivität der Spulen 13 bzw. 20 und zwar bei Annäherung der Membran 12 bzw. 19 und hochleitender Oberfläche in der Weise, daß sich die Induktivität vermindert; bei ferritischer Oberfläche in der Weise, daß sich die Induktivität erhöht. Die durch die Druckänderungen in den Druckdosen 11 bzw. 18 verursachten Induktivitätsänderungen in den Spulen 13 bzw. 20 machen sich in Änderungen der Frequenzen $f_1$ bzw. $f_2$ bemerkbar. Dadurch ändert sich ebenfalls das Ausgangssignal $\Delta f$ des Mischers 16. Dieses Ausgangssignal ist bei hinreichend linearen Kennlinien der Druckdose/Spulen-Anordnung ein ebenfalls lineares Maß für die Druckdifferenz im Saugrohr zum Außendruck.

Die erfindungsgemäße Anordnung läßt sich selbstverständlich auch dahingehend abwandeln, daß eine der Membranen 11, 18 fortgelassen und der jeweils zugehörige Oszillator damit bei einer festen Frequenz betrieben wird. Dann ist die Frequenz des Ausgangssignales des Mischers 16 ein Maß für den jeweils gemessenen Differenzdruck in der verbliebenen Druckdose gegenüber Außendruck oder den Absolutdruck in einer verbliebenen Absolut-Druckdose. Der Saugrohrdruck-Anschluß befindet sich in diesem Fall am abgedichteten Gehäuseteil in dem sich die evakuierte Absolut-Druckdose befindet.

Die Verwendung zweier Oszillatoren 15, 22 auch bei der Messung des Absolutdruckes hat dabei den Vorteil, daß Drifterscheinungen in der Frequenz der Oszillatoren 15, 22 kompensiert werden können. Hierzu werden erfindungsgemäß die Oszillatoren 15, 22 baugleich ausgestaltet und räumlich so dicht beieinander angeordnet, daß sie der gleichen Umgebungstemperatur ausgesetzt sind. Ändert sich nun die Frequenz der Oszillatoren 15, 22 in Folge von Änderungen der Umgebungstemperatur, machen sich diese gleichsinnigen Frequenzänderungen im Ausgangssignal des Mischers 16 nicht bemerkbar.

In Figur 2 ist das Schaltbild einer Ausführungsform eines Oszillators dargestellt, wie er für die Oszillatoren 15, 22 in Figur 1 verwendet werden kann. Dabei sind die frequenzbestimmenden Elemente: Spule 13 und Kondensator 14 in Reihenschaltung zwischen Betriebsspannung $U_B$ und Masse geschaltet. Vom Verbindungspunkt der Elemente 13, 14 führt die Schaltstrecke eines Transistors 30, die mit einem Kondensator 31 überbrückt ist, an die Parallelschaltung eines Kondensators 33 und eines Widerstandes 34, die an ihrer anderen Seite ebenfalls mit Masse verbunden sind. Die Basis des Transistors 30 ist über einen Widerstand 32 mit Masse und über einen Widerstand 35 mit Betriebsspannung verbunden. Die Betriebsspannungsleitung ist weiterhin über einen Kondensator 38 an Masse angeschlossen. Den Ausgang des Oszillators bilden zwei in Reihe geschaltete Kondensatoren 36, 37, die parallel zum Kondensator 14 angeordnet sind, wobei das Ausgangssignal mit der Frequenz $f_1$ im dargestellten Ausführungsbeispiel am Verbindungspunkt der Kondensatoren 36, 37 abgegriffen werden kann.

In Figur 3a ist die Rückseite und in der Figur 3b die Vorderseite eines Dünnschichtelementes 40 dargestellt, mit dem ein Oszillator realisiert wird, dessen Schaltbild in Figur 2 gegeben ist. Auf der Vorderseite ist dabei die als flächige Spirale ausgebildete Spule 13 zu erkennen. Auf der Rückseite befinden sich die weiteren Schaltelemente des Oszillators, wobei zum Verständnis die nicht auf der Rückseite angeordnete Spule 13 und der Transistor 30 gestrichelt eingezeichnet sind. Wie aus Figur 3a ersichtlich, sind die Kondensatoren 31, 36 des Oszillators als sogenannte Fingerkondensatoren ausgebildet, d.h. als solche Bereiche der leitenden Deckschicht des Dünnschichtelementes, die fingerartig ineinandergreifen. Demgegenüber sind die Kondensatoren 14, 33, 37, 38 als flächige Beläge ausgebildet, bei denen der Kondensator durch die in Figur 3a erkenntlichen Bereiche und die in Figur 3b gezeigte geerdete Vorderseite gebildet werden. Die Widerstände 32, 34, 35 sind in bekannter Weise als Mäander bzw. dünne Bahnen ausgebildet.

Die als flächige Spirale ausgebildete Spule 13 steht dabei der im geringen Abstand hierzu angeordneten Membran 12 mit hochleitender oder ferritischer Oberfläche gegenüber. Dabei bewirkt die druckabhängige Auslenkung der Membran 12 eine Induktivitätsveränderung der Spule 13, wie oben im einzelnen beschrieben. Es versteht sich von selbst, daß durch die Wahl der Geometrie der Schwingkreiselemente auf dem Dünnschichtelement 40 die Druck/Frequenz-Kennlinie entsprechend beeinflußt werden kann, so daß sowohl lineare wie auch progressive oder degressive Kennlinien erzielbar sind. Es versteht sich weiterhin, daß statt eines Dünnschichtelementes auch eine kaschierte Leiterplatte oder ein Dickschichtelement Verwendung finden kann.

## Patentansprüche

1. Induktiver Drucksensor
a) mit einer ersten, flächigen Oszillatorspule (13), einem ersten Kondensator (14) und einem daran angeschlossenen ersten Oszillator (15),
b) mit einer zweiten, flächigen Oszillatorspule (20), einem zweiten Kondensator (21) und einem daran angeschlossenen zweiten Oszillator (22),
c) mit einem Mischer (16), dem die Ausgangssignale der Oszillatoren (15, 22) zugeführt werden,
d) mit einer ersten Membran (12), die mit der ersten Oszillatorspule (13) in elektromagnetischer Wirkverbindung steht, dadurch gekennzeichnet,
e) daß eine zweite Membran (19) mit der zweiten Oszillatorspule (20) in elektromagnetischer Wirkverbindung steht,
f) daß die erste und die zweite Membran (12, 19) unterschiedlichen Drücken ausgesetzt sind
g) daß die beiden Spulen (13, 20) so angeordnet sind, daß die unterschiedlichen Drücke einzeln bestimmt sind.
h) daß die Oberflächen beider Membranen (12, 19) aus hochleitendem oder ferritischem Material bestehen,
i) daß die Oszillatorspulen (13, 20) auf der der jeweiligen Membranoberfläche zugewandten Seite eines Trägers aufgebracht sind, wobei eine Oberfläche des Trägers im wesentlichen parallel zu der Ebene der in Wirkverbindung stehenden Membranoberfläche angeordnet ist und mindestens die Kondensatoren (14, 21) sich getrennt von den Oszillatorspulen (13, 20) außerhalb des Meßbereichs auf dem Träger befinden.

2. Induktiver Drucksensor nach Anspruch 1, dadurch gekennzeichnet, daß sich mindestens die Kondensatoren (14, 21), die Oszillatoren (15, 22) und der Mischer (16) auf der der Membranoberfläche abgewandten Seite des Trägers befinden.

3. Induktiver Drucksensor nach einem der Ansprüche 1 oder 2 dadurch gekennzeichnet, daß die erste Membran eine raumfeste Oberfläche besitzt.

4. Induktiver Drucksensor nach einem der Ansprüche 1 bis 3, dadurch gekennzeichnet, daß eine Oszillatorspule und der daran angeschlossene Oszillator eine Dünnschichtschaltung bilden.

5. Induktiver Drucksensor nach einem der Ansprüche 1 bis 3, dadurch gekennzeichnet, daß eine Oszillatorspule und der daran angeschlossene Oszillator eine Dickschichtschaltung bilden.

6. Induktiver Drucksensor nach einem der Ansprüche 1 bis 3, dadurch gekennzeichnet, daß eine Oszillatorspule und der daran angeschlossene Oszillator auf einer gedruckten Leiterplatte aufgebracht sind.

7. Induktiver Drucksensor nach einem der Ansprüche 1 bis 6, dadurch gekennzeichnet, daß die Geometrie einer Oszillatorspule und des daran angeschlossenen zweiten Oszillators auf eine gewünschte Druck/Frequenz-Kennlinie abgestimmt sind.

## Claims

1. Inductive pressure sensor
a) with a first, flat oscillator coil (13), a first capacitor (14) and a first oscillator (15) connected thereto
b) with a second, flat oscillator coil (20), a second capacitor (21) and a second oscillator (22) connected thereto,
c) with a mixer (16), to which the output signals of the oscillators (15, 22) are supplied,
d) with a first diaphragm (12), which is in effective electromagnetic connection with the first oscillator coil (13), characterized in that
e) a second diaphragm (19) is in effective electromagnetic connection with the second oscillator coil (20),
f) the first and the second diaphragm (12, 19) are subjected to different pressures,
g) the two coils (13, 20) are arranged in such a way that the different pressures are individually determined,
h) the surfaces of the two diaphragms (12, 19) consist of highly conductive or ferritic material,
i) the oscillator coils (13, 20) are mounted on the side of a base facing the respective diaphragm surface, the surface of the base being arranged substantially parallel to the plane of the diaphragm surface in effective connection and at least the capacitors (14, 21) being located on the base separate from the oscillator coils (13, 20) outside the measuring area.

2. Inductive pressure sensor according to Claim 1, characterized in that at least the capacitors (14, 21), the oscillators (15, 22) and the mixer (16) are located on the side of the base facing away from the diaphragm surface.

3. Inductive pressure sensor according to one of Claims 1 or 2, characterized in that the first diaphragm has a space-bound surface.

4. Inductive pressure sensor according to one of Claims 1 to 3, characterized in that an oscillator coil and the oscillator connected thereto form a thin-film circuit.

5. Inductive pressure sensor according to one of Claims 1 to 3, characterized in that an oscillator coil and the oscillator connected thereto form a thick-film circuit.

6. Inductive pressure sensor according to one of Claims 1 to 3, characterized in that an oscillator coil and the oscillator connected thereto are mounted on a printed circuit board.

7. Inductive pressure sensor according to one of Claims 1 to 6, characterized in that the geometry of one oscillator coil and the second oscillator connected thereto are adapted to the desired pressure/frequency characteristic.

**Revendications**

1. Jauge inductive de pression
a) avec une première bobine plate d'oscillateur (13), un premier condensateur (14) et un premier oscillateur (15) raccordé à ce condensateur,
b) avec une seconde bobine plate d'oscillateur (20), un deuxième condensateur (21) et un deuxième oscillateur (22) raccordés à ce condensateur,
c) avec un mixeur (16) auquel sont appliqués les signaux de sortie des oscillateurs (15, 22),
d) avec une première membrane (12) qui est en liaison opérationnelle électro-magnétique avec la première bobine d'oscillateur (13)
e) une deuxième membrane (19) étant en liaison opérationnelle électro-magnétique avec la deuxième bobine d'oscillateur (20),
f) la première et la deuxième membranes (12, 19) étant soumises à des pressions différentes,
g) les deux bobines (13, 20) sont prévues de façon qu'elles soient raccordées à des pressions différentes,
h) les surfaces des deux membranes (19) sont constituées d'un matériau hautement conducteur ou bien ferritique,
i) les bobines d'oscillateurs (13, 20) sont rapportées sur la face d'un support tournée vers les surfaces respectives des membranes, la surface du support étant disposée essentiellement parallèlement au plan des surfaces de membranes se trouvant en liaison opérationnelle tandis qu'au moins les condensateurs (14, 21) se situent séparément des bobines d'oscillographes (13, 20) en dehors de la zone de mesure sur le support.

2. Jauge inductive de pression selon la revendication 1, caractérisée en ce qu'au moins les condensateurs (14, 21), les oscillateurs (15, 22) et le mixeur (16) se trouvent sur la face du support opposée à la surface de la membrane.

3. Jauge inductive de pression selon une des revendications 1 ou 2, caractérisée en ce que la première membrane comporte une surface fixe.

4. Jauge inductive de pression selon une des revendicatione 1 à 3, caractérisée en ce qu'une bobine d'oscillateur et l'oscillateur qui lui est raccordé, constituent un circuit en couche mince.

5. Jauge inductive de pression selon une des revendications 1 à 3, caractérisée en ce qu'une bobine d'oscillateur et 1 oscillateur qui lui est raccordé, constituent un circuit en couche épaisse.

6. Jauge inductive de pression selon une des revendications 1 à 3, caractérisée en ce qu'une bobine d'oscillateur et l'oscillateur qui lui est raccordé, sont rapportés sur une plaque de circuits imprimés.

7. Jauge inductive de pression selon une des revendicatione 1 à 6, caractérisée en ce que la géomètrie d'une bobine d'oscillateur et du second oscillateur qui lui est raccordé, sont accordée à une courbe caractéristique souhaitable pression/fréquence,

# FIG. 1

# FIG. 2

0 060 256

FIG.3a

FIG.3b